(19) Europäisches Patentamt
European Patent Office
Office européen des brevets

(11) **EP 1 518 256 B1**

(12) **FASCICULE DE BREVET EUROPEEN**

(45) Date de publication et mention de la délivrance du brevet:
**19.12.2018 Bulletin 2018/51**

(21) Numéro de dépôt: **03756046.3**

(22) Date de dépôt: **03.06.2003**

(51) Int Cl.:
*H01J 37/32* [(2006.01)]     *H05H 1/46* [(2006.01)]

(86) Numéro de dépôt international:
**PCT/FR2003/001661**

(87) Numéro de publication internationale:
**WO 2003/103003 (11.12.2003 Gazette 2003/50)**

(54) **DISPOSITIF DE PRODUCTION D'UNE NAPPE DE PLASMA**

VERFAHREN ZUR ERZEUGUNG EINES GROSSFLÄCHIGEN PLASMAS

DEVICE FOR PRODUCTION OF A PLASMA SHEET

(84) Etats contractants désignés:
**DE FR GB**

(30) Priorité: **04.06.2002 FR 0206837**

(43) Date de publication de la demande:
**30.03.2005 Bulletin 2005/13**

(73) Titulaires:
- **CENTRE NATIONAL DE LA RECHERCHE SCIENTIFIQUE -CNRS-
75016 Paris (FR)**
- **Boreal Plasmas
42160 Andrezieux Boutheon (FR)**

(72) Inventeurs:
- **LAGARDE, Thierry, Léon
F-38450 Vif (FR)**
- **LACOSTE, Ana
F-38950 St Martin le Vinoux (FR)**
- **PELLETIER, Jacques
F-38400 Saint Martin D'Hères (FR)**
- **ARNAL, Yves, Alban-Marie
F-38320 Poisat (FR)**

(74) Mandataire: **Bréda, Jean-Marc et al
Marks & Clerk France
Conseils en Propriété Industrielle
Immeuble " Visium "
22 Avenue Aristide Briand
94117 Arcueil Cedex (FR)**

(56) Documents cités:
EP-A- 1 075 168     FR-A- 2 702 119
JP-A- H07 135 093     US-A- 6 060 836
US-A- 6 114 811

## Description

DOMAINE TECHNIQUE GENERAL DE L'INVENTION

La présente invention concerne le domaine technique général de la production de plasmas à pression intermédiaire excités par une puissance micro-onde.

Plus précisément l'invention concerne la production de nappes de plasmas denses, de grandes dimensions devant l'épaisseur du plasma, dans le domaine des moyennes pressions ou pressions intermédiaires, c'est-à-dire de l'ordre de quelques dixièmes de Pa à quelques milliers de Pa, ou de l'ordre de quelques millitorr à quelques dizaines de torr. (On rappelle que 1 torr vaut approximativement 133 Pa)

La présente invention concerne des applications très diverses, telles que les traitements de surface, par exemple le nettoyage des surfaces défilant à grande vitesse, et surtout le dépôt de diamants par dépôt chimique en phase vapeur assistée par plasma (CVD plasma - « Chemical Vapor Déposition » plasma selon la terminologie anglo-saxonne généralement utilisée).

En particulier, l'invention présente un intérêt pour les applications nécessitant des procédés utilisant des plasmas uniformes à des pressions intermédiaires sur de grandes surfaces.

ETAT DE L'ART

Toutes les applications sus-mentionnées nécessitent la production préalable d'un plasma dense et uniforme dans une enceinte, par exemple dans celle où se déroule l'application.

On rappelle qu'un plasma est un milieu gazeux, conducteur, constitué d'électrons, d'ions et de particules neutres, macroscopiquement neutre électriquement. Un plasma est obtenu notamment par ionisation d'un gaz par les électrons.

Généralement, les dépôts de diamant par CVD plasma sont effectués dans des plasmas d'hydrogène, contenant un faible pourcentage de méthane à une pression totale de quelques dizaines de torr, et une température de substrats de l'ordre de 600 à 800° C, voire plus.

Le mélange peut contenir aussi des gaz précurseurs pour le dopage du diamant, ou des impuretés modifiant la croissance du diamant.

Les plasmas utilisés pour les dépôts de diamant par CVD plasma sont généralement excités par des micro-ondes. Deux types de procédés d'excitation dans des réacteurs sont possibles.

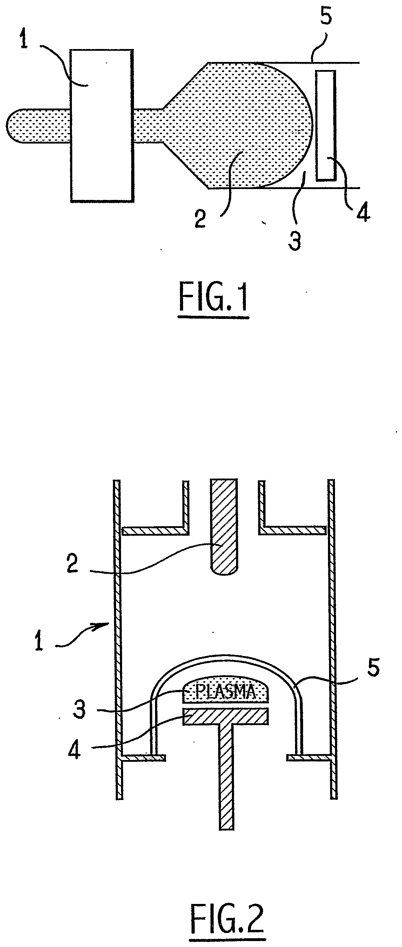

1/ On peut exciter le plasma par une onde de surface. Le schéma de principe de ce type d'excitateur est représenté sur la figure 1.
L'excitateur du plasma comporte un applicateur micro-onde 1 dans le prolongement duquel est fixé un tube diélectrique 2 directement en contact avec le plasma 3 à exciter. Le tube diélectrique 2 comporte un évasement 5, qui dirige les micro-ondes et le plasma vers le substrat 4, qui baigne dans le plasma 3.

2/ On peut utiliser un applicateur micro-onde de type cavité. Le schéma de principe de ce type d'applicateur est représenté à la figure 2.
Dans un réacteur 1, le plasma 3 est produit en réponse à une excitation de la part d'une antenne 2 permettant le couplage des micro-ondes à la cavité. Le plasma 3 est excité sous un dôme de quartz 5. Le dépôt est effectué sur un substrat 4 disposé lui aussi sous le dôme 5 et baignant dans le plasma 3.

Les deux types d'excitation présentés permettent de produire des plasmas denses (typiquement $10^{12}/cm^3$) permettant de déposer du diamant, notamment à une vitesse de quelques micromètres par heure, sur des substrats de quelques centimètres de diamètre.

Les techniques précédentes présentent cependant des inconvénients.

En effet, les plasmas produits par ces deux techniques nécessitent pour leur entretien plusieurs kW pour un substrat de diamètre 100 mm, et donc l'inconvénient majeur de ces techniques de dépôt de diamant est la difficulté d'extension d'échelle des réacteurs.

En ce qui concerne les décharges à onde de surface de la figure 1, le diamètre utile de plasma peut être accru par évasement du tube de silice 5 utilisé au-delà de l'applicateur micro-onde 1. Il faut cependant des densités de puissance micro-onde telles, que l'emploi d'un liquide de refroidissement sans perte diélectrique est impératif. La circulation de ce fluide s'effectue dans l'applicateur, dans un circuit de distribution à double paroi qui est très onéreux.

De plus, l'extension d'échelle de ce type de réacteur présente des limitations technologiques en terme de diamètre maximum réalisable. En effet, la puissance micro-onde délivrée par un générateur unitaire ne peut pas être augmentée de façon sensible. Les générateurs micro-ondes disponibles en mode continu à 2,45 GHz ne dépassent en effet généralement pas 12kW, ce qui est insuffisant pour produire des plasmas permettant les applications visées.

Enfin les guides d'ondes rectangulaires standards en mode de propagation unique utilisés dans les applicateurs des micro-ondes ont des grands côtés ne dépassant pas 8,6 cm - ce qui correspond au standard européen.

La solution consistant à réduire la fréquence d'excitation et à utiliser la fréquence ISM (Industrielle, Scientifique et Médicale) de 915 MHz permet d'augmenter les dimensions des guides d'ondes - dans le rapport de l'inverse des fréquences - et d'obtenir des puissances unitaires en mode continu jusqu'à 30 kW.

Elle n'est cependant pas totalement satisfaisante. En effet, les dimensions des composants micro-ondes - tels que le piston court-circuit, les adaptateurs d'impédance, les bi-coupleurs pour la mesure des puissances - augmentent corrélativement. Il semble alors que les limites technologiques sont désormais atteintes, et que les diamètres maximaux du substrat que l'on peut traiter sont de l'ordre de 100 à 150 mm.

En ce qui concerne les décharges micro-ondes données par les applicateurs micro-onde de type cavité, les mêmes problèmes se posent.

En effet, l'augmentation d'échelle de la cavité impose soit de passer en cavité multimodes, ce qui ne permet plus d'obtenir un plasma uniforme au niveau du substrat, soit de diminuer la fréquence des micro-ondes jusqu'à 915 MHz. La diminution de fréquence procure les mêmes avantages que précédemment, mais procure également les mêmes inconvénients. On ne peut traiter que des substrats de diamètre maximal de l'ordre de 100 à 150 mm.

Le document JP-H07-135093 divulgue un dispositif de production de plasma selon le préambule de la revendication 1.

Le document EP 1 075 168 A1 divulgue un dispositif de production de plasma comportant une pluralité de dispositifs élémentaires d'excitation de plasma disposés en réseau bidimensionnel.

## PRESENTATION DE L'INVENTION

L'invention propose de pallier ces inconvénients.

Notamment, l'invention a pour objet la production d'une tranche ou d'une nappe de plasma de grandes dimensions dans le domaine de pression du torr, à savoir de l'ordre de quelques millitorr à quelques dizaines de torr.

La production de cette tranche ou de cette nappe s'effectue par excitation micro-onde du gaz, ce qui permet la production de plasma sur un volume dépendant des conditions opératoires, à savoir la pression et la puissance micro-onde injectée sur chaque applicateur.

A cet effet, l'invention propose un dispositif de production d'un plasma selon la revendication 1

L'invention est avantageusement complétée par les caractéristiques suivantes, prises seules ou en une quelconque de leur combinaison techniquement possible :

- le matériau diélectrique est réfractaire ;
- le matériau diélectrique est réalisé en alliage de silice et/ou de nitrure d'aluminium et/ou d'alumine ;
- la longueur du matériau diélectrique est égale à un nombre entier de demi longueur d'onde des micro-ondes dans le matériau diélectrique ;
- il comporte des joints toriques interposés entre le diélectrique, l'âme centrale d'un applicateur et la paroi interne de l'applicateur ;
- chaque joint torique est encastré dans les parois interne et externe de la structure coaxiale ;
- une âme centrale se termine par un aimant permanent encapsulé dans l'âme centrale et affleurant avec les parois de l'enceinte ;
-- il comporte une lame diélectrique qui s'étend à l'intérieur de l'enceinte sur la paroi intérieure de celle-ci, celle lame recouvrant complètement les dispositifs d'excitation du plasma ;
- il comporte dans les parois de l'enceinte des moyens de refroidissement de chaque applicateur ;
- il comporte dans l'âme centrale de chaque applicateur des moyens de refroidissement des applicateurs ;
- la pression du plasma est comprise entre une valeur de l'ordre du millitorr et une valeur de l'ordre de quelques dizaines de torr.

Dans ce qui suit on utilise l'expression "mode de réalisation", même pour les exemples qui ne sont pas couverts par la revendication 1. La protection recherchée est définie uniquement dans les revendications.

## PRESENTATION DES FIGURES

D'autres caractéristiques, buts et avantages de l'invention ressortiront de l'invention qui suit qui est purement illustrative et non limitative, et qui doit être lue en regard des dessins annexés sur lesquels :

La figure 1, déjà commentée, représente schématiquement un applicateur d'excitation du type onde de surface selon l'état de la technique ;

La figure 2, déjà commentée, représente schématiquement un réacteur d'excitation de plasma du type cavité selon l'état de la technique ;

La figure 3 est une vue schématique en coupe d'un mode de réalisation possible de l'invention comportant un seul applicateur ;

La figure 4 est une vue schématique en coupe d'un mode de réalisation possible de l'invention comportant plusieurs applicateurs ;

La figure 5 est une vue représentant une disposition rapprochée des applicateurs ;

La figure 6 est une vue de face d'un réseau bidimensionnel carré d'applicateurs ;

La figure 7 est une vue de face d'un réseau bidimensionnel hexagonal d'applicateurs ;

La figure 8 représente le recouvrement de la paroi du réacteur avec une plaque diélectrique ;

La figure 9 représente schématiquement un mode de réalisation possible de montage de joints toriques d'étanchéité; et

La figure 10 est une représentation d'un perfectionnement d'un mode de réalisation de l'invention comportant un aimant permanent à l'extrémité de l'applicateur.

## DESCRIPTION DETAILLEE DE L'INVENTION

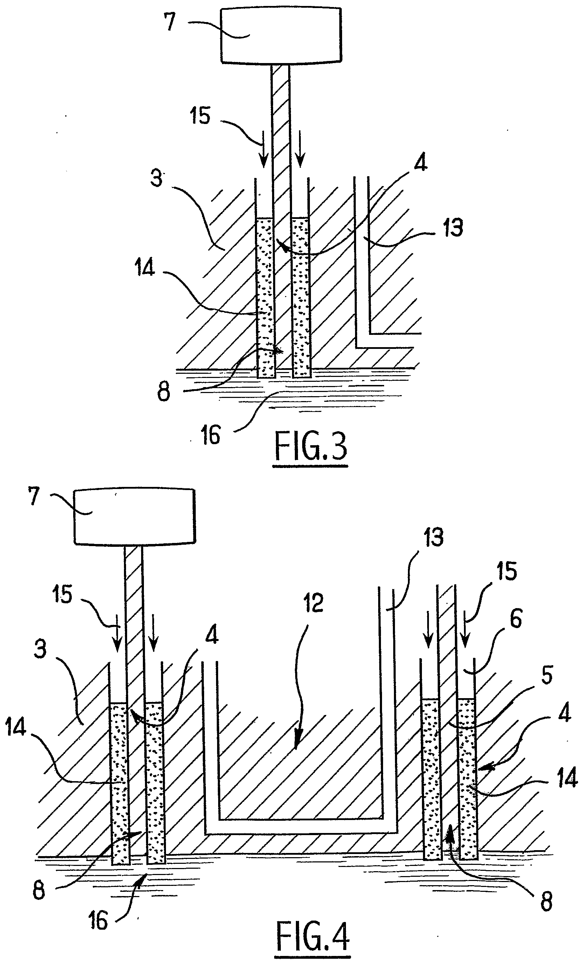

La figure 3 illustre schématiquement un mode de réalisation possible d'un dispositif 1 de production d'un plasma.

Le dispositif 1 comprend de façon classique une enceinte étanche 3, équipée de nombreux dispositifs d'introduction de gaz et de pompage de gaz, non représentés mais connus en eux-mêmes. Les dispositifs d'introduction et de pompage permettent de maintenir la pression du gaz à ioniser à une valeur souhaitée - qui peut être par exemple de l'ordre de quelques dixièmes de Pa à quelques milliers de pascals, c'est-à-dire de l'ordre de quelques millitorr à quelques dizaines de torr, suivant la nature du gaz et la fréquence d'excitation.

Classiquement, la paroi de l'enceinte 3 est métallique.

Conformément à ce mode de réalisation possible de l'invention, le dispositif de production 1 comporte un applicateur élémentaire 4 d'excitation. Selon une variante de ce mode de réalisation schématiquement représenté à la figure 4, le dispositif de production du plasma comporte une série de dispositifs ou applicateurs 4 élémentaires d'excitation d'un plasma 16. Les applicateurs 4 sont alors répartis entre eux en fonction de la densité et de la pression intérieure de l'enceinte.

Conformément à l'invention, chaque dispositif élémentaire 4 d'excitation de plasma est constitué par un applicateur coaxial de puissance micro-onde comportant une âme centrale 5 entourée d'une cavité 6 rapportée ou directement percée dans la paroi de l'enceinte 3.

Préférentiellement, l'âme centrale 5 ainsi que la cavité 6 l'entourant sont de symétrie de révolution.

Une des extrémités de l'applicateur 4 est reliée à une source d'énergie 7 dans le domaine des micro-ondes et extérieure à l'enceinte 3.

L'autre extrémité 8 de l'applicateur 4 est libre et débouche à l'intérieur de l'enceinte 3. Elle est en contact avec le gaz présent dans l'enceinte 3.

La propagation de l'énergie micro-onde de la source d'énergie 7 à l'extrémité libre 8 s'effectue dans la cavité 6 entourant l'âme centrale de l'applicateur.

De manière générale, l'âme centrale 5 de chaque applicateur 4 est refroidie par un circuit de circulation d'eau (non représenté sur les figures).

De la même façon, les figures 3 et 4 montrent que les espaces 12 entre les applicateurs 4 de la paroi 3 sont généralement refroidis par une circulation d'eau 13.

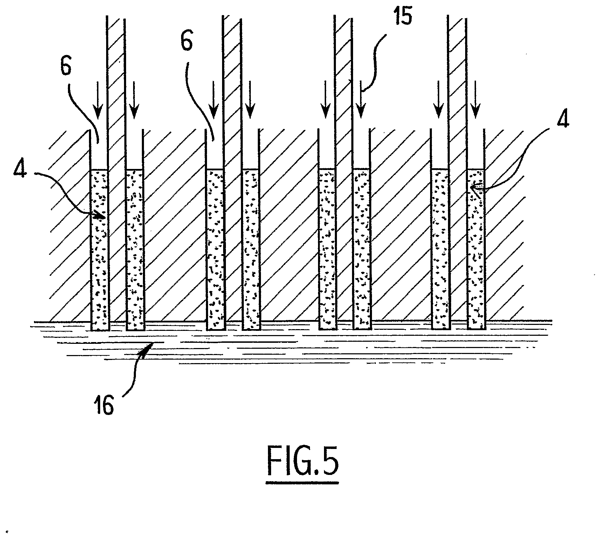

Un matériau diélectrique 14 à l'état solide est disposé à l'intérieur de la cavité 6 autour de l'âme centrale 5. Le diélectrique 14 est disposé du côté de l'extrémité libre 8 de l'applicateur 4, sensiblement au niveau de la paroi de l'enceinte. Il peut légèrement dépasser de la paroi de l'enceinte 3 ou être légèrement enfoncé par rapport au niveau de la paroi de l'enceinte 3, laquelle affleure préférentiellement sensiblement le niveau de l'extrémité de l'âme centrale 5 en contact avec le plasma, comme représenté sur la figure 5.

Selon l'invention il remplit l'ensemble de l'espace entre l'âme centrale et la paroi intérieure de la cavité.

Préférentiellement, la longueur du matériau diélectrique est égale à un nombre entier de demi longueur d'onde de l'onde dans le diélectrique, ceci afin de compenser les réflexions et recompositions des ondes aux interfaces. La longueur I du diélectrique est définie par :

$$\sqrt{\varepsilon_r} \times l = k \times \frac{\lambda}{2}$$

où : $\varepsilon_r$ est la permittivité relative du matériau diélectrique

k est un nombre entier

$\lambda$ est la longueur d'onde de l'onde dans le vide.

Le diélectrique 14 est avantageusement « à faible perte ». Il est de préférence réfractaire afin de résister aux fortes températures de certaines applications visées. Il peut être réalisé en alliage par exemple en nitrure d'aluminium (AlN), et/ou en alumine ($Al_2O_3$), et/ou en silice ($SiO_2$).

Les flèches 15 visibles aux figures 3, 4 et 5 représentent la propagation des ondes micro-ondes dans la cavité 6 de chaque applicateur 4. Elles se propagent en direction de l'intérieur de l'enceinte 3 et excite le plasma 16 situé dans ladite enceinte 3.

Les figures 4 et 5 permettent de comparer l'influence de la distance de séparation des applicateurs les uns par rapport aux autres sur la formation du plasma.

On a besoin d'une densité relativement réduite d'applicateurs par unité de surface pour produire un plasma uniforme lorsque la pression du gaz est relativement faible. En effet, le plasma diffuse plus facilement lorsque la pression du gaz est peu élevée. On peut alors ne prévoir qu'un seul applicateur 4 pour la production du plasma sur une dimension donnée.

Par contre, plus la pression du gaz est élevée, plus le plasma sera produit localement. Le plasma ne sera pas uniforme si les applicateurs sont trop éloignés, comme sur la figure 4. On aura donc besoin d'une densité plus importante d'applicateurs par unité de surface, les applicateurs étant eux aussi répartis de façon la plus uniforme possible.

C'est aussi pour cette raison que matériau diélectrique est situé à l'extrémité de l'applicateur, et non pas en retrait par rapport à cette extrémité. Ainsi, on évite la formation de plasma dans l'intérieur de l'applicateur (zone coaxiale, côté utilisation) dans tout le domaine de pression accessible.

Les applicateurs 4 peuvent être disposés selon différents réseaux.

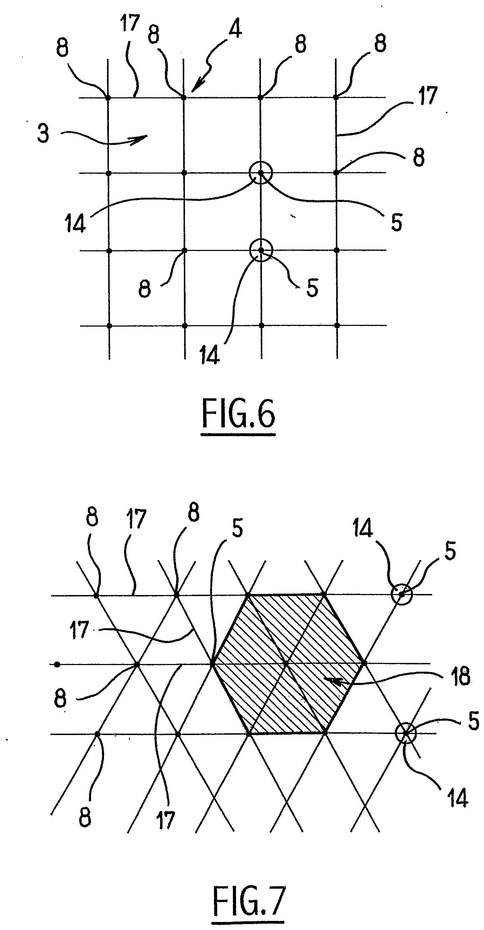

La figure 6 montre une vue de face de la paroi interne de l'enceinte 3. Elle représente la disposition en réseau des extrémités libres 8 des applicateurs 4. Dans ce réseau carré, la distance 17 entre deux extrémités libres 8 définit la densité du réseau.

La figure 7 montre que, pour une même distance 17 entre deux extrémités libres 8, une disposition en réseau hexagonal - schéma référencé par 18 sur la figure - permet d'obtenir une plus grande densité aréolaire d'applicateurs 4.

Une densité plus grande permet une meilleure uniformité d'applicateurs 4, et par conséquent une meilleure uniformité du plasma ainsi produit. On peut également fournir une plus grande densité de puissance micro-onde par unité de surface, à puissance maximale donnée par applicateur 4.

Pour des raisons de clarté, les figures 6 et 7 ne montrent schématiquement que deux extrémités d'applicateurs 4. On distingue les extrémités 5 des âmes centrales, ainsi que les matériaux diélectriques 14.

Pour obtenir une nappe de plasma 16 uniforme de très grandes dimensions, une condition nécessaire est de pouvoir distribuer la puissance micro-onde de façon aussi uniforme que possible sur l'ensemble des applicateurs 4.

Pour cela, il est possible d'utiliser un générateur de puissance micro-onde réglable par applicateur. On peut alors utiliser par exemple pour chaque applicateur une source micro-onde transistorisée.

On peut également utiliser un générateur de puissance micro-onde unique et diviser ensuite cette puissance pour la distribuer à chaque applicateur 4. La puissance micro-onde injectée dans chaque applicateur 4 peut être ajustée facilement et de façon indépendante par un adaptateur d'impédance, disposé juste en amont de chaque applicateur 4.

Certains procédés de dépôt ou de traitement nécessitent une température élevée de la surface d'utilisation. D'autres nécessitent des températures plus basses.

On rappelle que les parties 12 situées entre deux applicateurs, ainsi que les âmes centrales 5 sont refroidies par des circuits de refroidissement par circulation de fluide, notamment d'eau.

Par conséquent, il est possible que les gaz constituant le plasma soient refroidis en passant au contact des surfaces refroidies de l'enceinte 3 et refroidissent à leur tour la surface d'utilisation.

On prévoit ainsi un chauffage indépendant d'une surface d'utilisation notamment pour le dépôt de diamant.

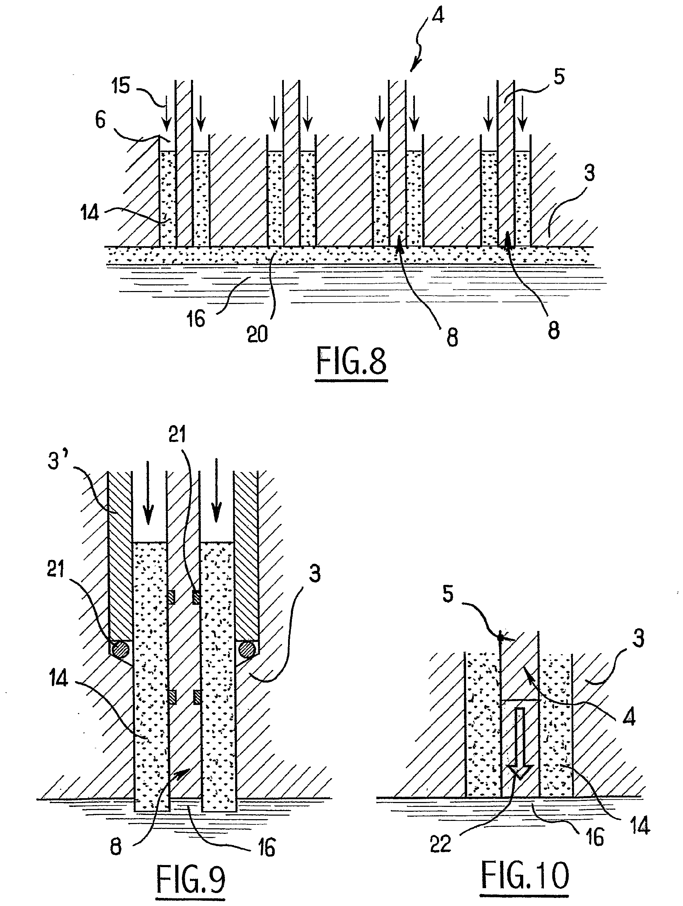

La figure 8 montre que l'on peut également interposer une lame diélectrique 20 à faible perte (comme de la silice par exemple) entre les parties refroidies de chaque applicateur et le plasma, afin d'éviter le refroidissement du plasma au contact des surfaces refroidies par la circulation de fluide. La lame diélectrique 20 peut recouvrir tout ou une partie de l'ensemble des extrémités libres 8 des applicateurs 4.

La figure 9 montre que des joints toriques 21 permettent l'étanchéité entre les parties amont (atmosphère) et aval (plasma) des applicateurs 4.

Les joints toriques 21 sont de préférence encastrés dans l'âme centrale 5 et entre les parois de l'enceinte 3 et le presse étoupe 3', afin d'éviter leur échauffement par le passage des micro-ondes. De plus, ce type d'encastrement permet également d'assurer un meilleur refroidissement, puisqu'ils profitent du circuit de distribution de refroidissement présent dans la paroi 3 ainsi que dans chaque âme centrale 5.

Le dispositif selon l'invention représenté sur les figures 1 à 9 s'applique avantageusement au domaine des moyennes pressions (de l'ordre de quelques dixièmes de pascals à quelques milliers de pascals, c'est-à-dire de l'ordre de quelques millitorr à quelques dizaines de torr).

Cependant, si on souhaite étendre l'utilisation de l'invention pour une excitation du plasma dans le domaine des basses pressions (de l'ordre de $10^{-2}$ torr), une variante du dispositif est envisagée.

Sur cette variante, représentée à la figure 10, on dispose à l'extrémité de l'âme centrale 5 de l'applicateur 4 un aimant permanent 22 dont l'axe d'aimantation permanente est avantageusement dans l'axe de l'âme centrale. Cet aimant 22 est encapsulé dans l'âme centrale 5. L'extrémité libre de l'aimant est sensiblement au niveau de l'extrémité libre de la paroi 3 en contact avec le plasma 16.

Avec un tel aimant permanent 22, le démarrage du plasma est facilité dans le domaine des plus basses pressions visées par la présente invention, grâce au confinement de plasma ou à la présence d'une zone de RCE (Résonance Cyclotronique Electronique) près du pôle de l'aimant.

Chaque aimant permanent 22 peut être conventionnel, par exemple en samarium - cobalt, en néodyme - fer - bore, voire en ferrite de baryum et de strontium.

Le réacteur plasma décrit dans la présente demande comporte des moyens de mesure de pression et de diagnostic plasma souhaité (non visible sur les figures)

De même, un porte-substrat utilisé pour les procédés mis en oeuvre comporte des moyens de chauffage ou de refroidissement ainsi que tous les moyens de polarisation (continu, pulsée, basse fréquence ou radio fréquence) du substrat nécessaire au procédé utilisé.

AVANTAGES DE L'INVENTION

L'un des avantages apportés par la présente invention est la possibilité de réaliser l'extension d'échelle des nappes de plasma produite par ladite technologie décrite et de produire des plasmas denses dans la gamme de pression définie dans l'invention.

Il n'y a pas de limitation à augmenter le nombre d'applicateurs.

Les applicateurs peuvent être disposés selon n'importe quelle géométrie, et s'adaptent à n'importe quelle configuration d'enceinte, cylindrique notamment.

De même, il est possible d'alimenter en puissance micro-onde autant d'applicateurs que souhaité par autant de générateur indépendants que nécessaire, avec ou sans division de puissance.

Chaque applicateur peut être alimenté à l'aide d'un câble coaxial, puisque la puissance micro-onde nécessaire à chaque applicateur est relativement faible d'où la grande fiabilité dù dispositif global.

Un autre avantage est que le refroidissement des applicateurs micro-ondes est facile à assurer par une circulation de liquide dans la partie métallique des applicateurs. Il n'y a pas de nécessité de fournir un fluide diélectrique à faible perte comme dans le cas des décharges à onde de surface de l'état de la technique.

Enfin, le contrôle des paramètres interaction plasma/surface est plus facile à maîtriser que dans les dispositifs de l'état de la technique.

Par exemple, si l'on considère un réseau carré d'applicateurs micro-ondes coaxiaux, par exemple d'un diamètre intérieur du conducteur externe 16 mm disposés tous les deux centimètres, l'aire de chaque applicateur est de 4 cm$^2$. Cette aire est réduite à 3,5 cm$^2$ environ dans le cas d'une structure hexagonale.

Dans le cas d'une nappe de plasma de 2 cm d'épaisseur, fixée par exemple par la distance applicateur-surface d'utilisation, le volume de plasma crée par chaque applicateur est de 8 cm$^3$ pour un réseau carré, et de 7 cm$^3$ pour un réseau hexagonal.

Pour une puissance micro-onde par applicateur de 200 W, la densité de puissance maximale fournie au plasma est de 25 W/cm$^3$ pour un réseau carré, et de 28,5 W/cm$^3$ pour un réseau hexagonal.

Dans les deux cas, il est ainsi possible d'appliquer jusqu'à 5 kW par surface 100 mm x 100mm pour un réseau carré, soit 25 applicateurs, et un peu plus pour un réseau hexagonal.

Un autre avantage est la simplicité de réalisation de chaque applicateur élémentaire.

La fréquence micro-onde utilisée n'est pas critique, et il est possible d'utiliser l'une des fréquences ISM (Industrielle, Scientifique et Médicale) comme le 915 MHz ou le 2,45 GHz, ou toute autre fréquence.

## Revendications

1. Dispositif de production d'un plasma (16) dans une enceinte comportant des moyens de production d'une énergie dans le domaine des micro-ondes en vue de l'excitation du plasma, ces moyens comportant au moins un dispositif élémentaire d'excitation de plasma comportant un applicateur (4) coaxial d'une énergie micro- onde dont une des extrémités est reliée à une source de production (7) d'une énergie micro-onde, l'autre extrémité (8) étant dirigée vers le gaz à exciter à l'intérieur de l'enceinte, chaque dispositif élémentaire d'excitation étant disposé dans la paroi (3) de l'enceinte, chaque applicateur (4) comportant une âme centrale (5) qui affleure sensiblement avec la paroi de l'enceinte, l'âme centrale et l'épaisseur de la paroi (3) de l'enceinte étant séparées par un espace (6) coaxial à l'âme centrale, cet espace étant totalement rempli au moins à l'extrémité de chaque applicateur par un matériau diélectrique (14) de façon à ce que ledit matériau affleure sensiblement avec le niveau de la paroi de l'enceinte, **caractérisé en ce qu'**il comporte une pluralité desdits dispositifs élémentaires d'excitation de plasma disposés en réseau bidimensionnel, le matériau diélectrique remplissant tout l'espace coaxial (6) des âmes centrales des applicateurs desdits dispositifs élémentaires.

2. Dispositif selon la revendication 1, **caractérisé en ce que** le matériau diélectrique (14) est réfractaire.

3. Dispositif selon la revendication 2, **caractérisé en ce que** le matériau diélectrique (14) est réalisé en alliage de silice et/ou de nitrure d'aluminium et/ou d'alumine.

4. Dispositif selon l'une des revendications 1 à 3, **caractérisé en ce qu'**il comporte des joints toriques (21) interposés entre le diélectrique (14), l'âme centrale d'un applicateur et la paroi interne de l'applicateur.

5. Dispositif selon la revendication 4, **caractérisé en ce que** chaque joint torique (21) est encastré dans les parois interne et externe de la structure coaxiale.

6. Dispositif selon l'une des revendications 1 à 5, **caractérisé en ce qu'**une âme centrale (5) se termine par un aimant permanent (22) encapsulé dans l'âme centrale et affleurant avec les parois de l'enceinte.

7. Dispositif selon l'une des revendications 1 à 6, **caractérisé en ce qu'**il comporte une lame diélectrique (20) qui s'étend à l'intérieur de l'enceinte sur la paroi intérieure de celle-ci, cette lame recouvrant complètement les dispositifs d'excitation du plasma.

8. Dispositif selon l'une des revendications 1 à 7, **caractérisé en ce qu'**il comporte dans les parois de l'enceinte des moyens (12) de refroidissement de chaque applicateur (4).

9. Dispositif selon l'une des revendications 1 à 8, **caractérisé en ce qu'**il comporte dans l'âme centrale (5) de chaque applicateur (4) des moyens de refroidissement des applicateurs.

10. Dispositif selon l'une des revendications précédentes, **caractérisé en ce que** la pression du plasma (16) est comprise entre une valeur de l'ordre du millitorr et une valeur de l'ordre de quelques dizaines de torr.

## Patentansprüche

1. Vorrichtung zur Erzeugung eines Plasmas (16) in einer Einhausung, welche Mittel zur Erzeugung einer Energie im Bereich der Mikrowellen zum Erregen des Plasmas beinhaltet, wobei diese Mittel mindestens eine elementare Plasmaerregungsvorrichtung beinhalten, welche einen koaxialen Applikator (4) einer Mikrowellenenergie beinhaltet, dessen eines Ende mit einer Erzeugungsquelle (7) einer Mikrowellenenergie verbunden ist, wobei das andere Ende (8) auf das zu erregende Gas im Innern der Einhausung gerichtet ist, wobei jede elementare Erregungsvorrichtung in der Wand (3) der Einhausung angeordnet ist, wobei jeder Applikator (4) einen mittlere Kern (5) beinhaltet, welcher im Wesentlichen bündig an der Wand der Einhausung anliegt, wobei der mittlere Kern und die Dicke der Wand (3) der Einhausung durch einen zum mittleren Kern koaxialen Raum (6) getrennt sind, wobei dieser Raum vollständig mindestens am Ende eines jeden Applikators mit einem dielektrischen Material (14) in der Weise gefüllt ist, dass das Material im Wesentlichen mit der Höhe der Wand der Einhausung bündig anliegt, **dadurch gekennzeichnet, dass** sie eine Vielzahl der elementaren Plasmaerregungsvorrichtungen beinhaltet, welche in einem zweidimensionalen Netzwerk angeordnet sind, wobei das dielektrische Material den gesamten koaxialen Raum (6) der mittleren Kerne der Applikatoren der elementaren Vorrichtungen füllt.

**2.** Vorrichtung nach Anspruch 1, **dadurch gekennzeichnet, dass** das dielektrische Material (14) feuerfest ist.

**3.** Vorrichtung nach Anspruch 2, **dadurch gekennzeichnet, dass** das dielektrische Material (14) aus einer Silizium- und/oder einer Aluminiumnitrid- und/oder einer Aluminiumoxidlegierung besteht.

**4.** Vorrichtung nach einem der Ansprüche 1 bis 3, **dadurch gekennzeichnet, dass** sie O-Ringe (21) beinhaltet, welche zwischen dem Dielektrikum (14), dem mittleren Kern eines Applikators und der inneren Wand des Applikators zwischengeschaltet sind.

**5.** Vorrichtung nach Anspruch 4, **dadurch gekennzeichnet, dass** jeder O-Ring (21) in die innere und die äußere Wand der koaxialen Struktur eingelassen ist.

**6.** Vorrichtung nach einem der Ansprüche 1 bis 5, **dadurch gekennzeichnet, dass** ein mittlerer Kern (5) an seinem Ende einen Dauermagneten (22) aufweist, welcher im mittleren Kern verkapselt ist und bündig an den Wänden der Einhausung anliegt.

**7.** Vorrichtung nach einem der Ansprüche 1 bis 6, **dadurch gekennzeichnet, dass** sie ein dielektrisches Blatt (20) beinhaltet, welches sich in das Innere der Einhausung auf der Innenwand davon erstreckt, wobei dieses Blatt die Erregungsvorrichtungen des Plasmas vollständig überdeckt.

**8.** Vorrichtung nach einem der Ansprüche 1 bis 7, **dadurch gekennzeichnet, dass** sie in den Wänden der Einhausung Mittel (12) zum Kühlen eines jeden Applikators (4) beinhaltet.

**9.** Vorrichtung nach einem der Ansprüche 1 bis 8, **dadurch gekennzeichnet, dass** sie im mittleren Kern (5) eines jeden Applikators (4) Mittel zum Kühlen der Applikatoren beinhaltet.

**10.** Vorrichtung nach einem der vorhergehenden Ansprüche, **dadurch gekennzeichnet, dass** der Druck des Plasmas (16) zwischen einem Wert in der Größenordnung von einem Millitorr und einem Wert in der Größenordnung von mehreren zehn Torr liegt.

## Claims

**1.** A device for producing a plasma (16) in a chamber comprising means for producing an energy in the microwave spectrum for the excitation of the plasma, said means comprising at least one basic plasma excitation device comprising a coaxial applicator (4) of microwave energy, of which one end is connected to a production source (7) of microwave energy, the other end (8) being directed to the gas to be excited within the chamber, each basic excitation device being arranged in the wall (3) of the chamber, each applicator (4) comprising a central core (5) which is substantially flush with the wall of the chamber, the central core and the thickness of the wall (3) of the chamber being separated by a space (6) coaxial with the central core, this space being completely filled at least at the end of each applicator with a dielectric material (14) such that said material is substantially flush with the level of the wall of the chamber, **characterised in that** it comprises a plurality of said basic plasma excitation devices arranged in a bidimensional net, the dielectric material filling the whole coaxial space (6) of the central cores of the applicators of said basic devices.

**2.** The device according to claim 1, **characterised in that** the dielectric material (14) is refractory.

**3.** The device according to claim 2, **characterised in that** the dielectric material (14) is made of alloy of silica and/or of aluminium nitride and/or of alumina.

**4.** The device according to any of claims 1 to 3, **characterised in that** it comprises O-rings (21) inserted between the dielectric (14), the central core of an applicator and the internal wall of the applicator.

5. The device according to claim 4, **characterised in that** each O-ring (21) is embedded in the internal and external walls of the coaxial structure.

6. The device according to any of claims 1 to 5, **characterised in that** a central core (5) terminates in a permanent magnet (22) encapsulated in the central core and flush with the walls of the chamber.

7. The device according to any of claims 1 to 6, **characterised in that** it comprises a dielectric plate (20) that extends to the interior of the chamber on the internal wall thereof, said plate completely covering the plasma excitation devices.

8. The device according to any of claims 1 to 7, **characterised in that** it comprises means (12) for cooling each applicator (4) in the chamber walls.

9. The device according to any of claims 1 to 8, **characterised in that** it comprises means for cooling the applicators in the central core (5) of each applicator (4).

10. The device according to any of the preceding claims, **characterised in that** the pressure of the plasma (16) is between a value of about 1 millitorr and a value of about a few tens of torr.

FIG.1

FIG.2

EP 1 518 256 B1

FIG.3

FIG.4

## FIG.5

FIG.6

FIG.7

FIG.8

FIG.9

FIG.10

EP 1 518 256 B1

# RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- JP H07135093 B
- EP 1075168 A1